# EUROPEAN PATENT APPLICATION

(11) **EP 4 682 632 A2**
(43) Date of publication of application: **21.01.2026**
(21) Application number: 25207267.3
(22) Date of filing: 07.10.2025
(51) Int. Cl.: G03F 7/00

(54) **LIGHT SOURCE SYSTEM FOR USE IN A METROLOGY SYSTEM**

(71) Applicant: ASML Netherlands B.V., 5500 AH Veldhoven (NL)
(72) Inventor: YUCE, Emre, 5500 AH Veldhoven (NL)
(74) Representative: ASML Netherlands B.V.

(57) **Abstract**

A light source system configured to provide a fixed output light beam with fixed output wavelength and a variable output light beam with varying output wavelength comprising: a first light source to provide a first fixed light source beam of first fixed source wavelength; a second light source to provide a tunable light source beam of tunable source wavelength; one or more light beam combiner devices configured to provide the fixed output light beam either by combining the first fixed light source beam with the tunable light source beam tuned to a second fixed source wavelength or by combining the first fixed light source beam with a second fixed light source beam. The one or more light beam combiner devices are configured to provide the variable output light beam by combining the first fixed light source beam with the tunable light source beam tuned to a varying source wavelength.

## Description

### FIELD

The present invention relates to the field of lithography. In particular, the present invention relates to a light source system for use in a metrology system, an interferometer system, a projection system for an optical lithography system, and an exposure apparatus.

### BACKGROUND

A lithographic apparatus is a machine constructed to apply a desired pattern onto a substrate. A lithographic apparatus can be used, for example, in the manufacture of integrated circuits (ICs).A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In metrology tools for lithography, position-related measurements such as relative displacement and absolute displacement measurements are performed. These measurements are used, for example, to determine movement and/or position of moving parts during a lithographic exposure process, for example of a stage support structure such as an object table or a wafer table, and/or of a projection system of the lithographic apparatus, such as mirrors. Light sources are used within these metrology tools to perform the various measurements. The light sources, such as lasers, emit light beams, such as laser beams, at a particular frequency. The frequency of the light beam emitted by a light source may be fixed - i.e., the light source is configured to emit a light beam at a fixed frequency/wavelength. Alternatively, the frequency of the light beam emitted by a light source may be variable - i.e., the light source is configured to emit a light beam at a variable frequency/wavelength. For such a variable-frequency light source, the metrology tool may be configured to perform a sweep across frequencies/wavelengths. During such a sweep, the variable-frequency light source successively emits light at different frequencies within a frequency sweep range. For example, the frequency sweep range is 0.5nm.

To measure relative position, a fixed frequency light beam is emitted. During measurement, a phase change between reference arm and measurement arm is determined as the result of displacement of the moving part being measured. To measure absolute position, a variable frequency light beam is emitted and a sweep is performed over a predefined frequency range. During measurement, the slope of phase change between reference arm and measurement arm may be used to determine the absolute position of the moving part being measured.

To construct accurate metrology tools, appropriate light sources are required. The fixed light source preferably outputs a narrow linewidth light beam used for precision displacement measurements. In certain cases, the light beams emitted by multiple pump lasers is combined by a nonlinear crystal, e.g., a periodically poled lithium niobate (PPLN) crystal to generate the appropriate fixed light beam. Alternatively, the nonlinear crystals may comprise Potassium Dihydrogen Phosphate (KDP), Beta-Barium Borate, or another appropriate non-linear crystalline material. The light beam output by the tunable light source preferably has a large tuning range. For example, the tunable light source may be a distributed feedback laser which is temperature-tuned over a range of approximately 0.5nm.

It is desirable to increase reliability of the light sources of these metrology tools, as well as to decrease their cost of manufacturing. It is further desirable to provide for variable light sources that offer fast and accurate tuning over a large tuning range.

### SUMMARY

According to a first aspect of the invention, there is provided a light source system configured to provide a fixed output light beam with a fixed output wavelength and a variable output light beam with a varying output wavelength. The light source system comprises a first light source configured to provide a first fixed light source beam of a first fixed source wavelength, a second light source configured to provide a tunable light source beam of a tunable source wavelength, and one or more light beam combiner devices configured to combine a plurality of light source beams.

According to one alternative of the first aspect of the invention, the one or more light beam combiner devices are configured to provide the fixed output light beam with the fixed output wavelength by combining the first fixed light source beam with the tunable light source beam tuned to a second fixed source wavelength, and the one or more light beam combiner devices are configured to provide the variable output light beam with the varying output wavelength by combining the first fixed light source beam with the tunable light source beam tuned to a varying source wavelength.

According to another alternative of the first aspect of the invention, the light system comprises a third light source configured to provide a second fixed light source beam of the second fixed source wavelength. The one or more light beam combiner devices are configured to provide the fixed output light beam with the fixed output wavelength by combining the first fixed light source beam with the second fixed light source beam, and the one or more light beam combiner devices are configured to provide the variable output light beam with the varying output wavelength by combining the first fixed light source beam with the tunable light source beam tuned to the varying source wavelength.

In an embodiment, the light source system is configured to provide the fixed output light beam and the variable output light beam simultaneously.

In a variant of this embodiment, the one or more light beam combiner devices comprise a first light beam combiner device and a second light beam combiner device. The first light beam combiner device is configured to provide the fixed output light beam with the fixed output wavelength by combining the first fixed light source beam with the second fixed light source beam, and the second light beam combiner device is configured to provide the variable output light beam with the varying output wavelength by combining the first fixed light source beam with the tunable light source beam tuned to the varying source wavelength.

In an embodiment, the light source system is configured to alternate the providing of the fixed output light beam and the variable output light beam.

In a variant of this embodiment, one light beam combiner device is configured to provide the fixed output light beam with the fixed output wavelength by combining the first fixed light source beam with the second fixed light source beam and to provide the variable output light beam with the varying output wavelength by combining the first fixed light source beam with the tunable light source beam tuned to the varying source wavelength.

In an example of this variant, the second light source and the third light source are configured to alternatingly provide the tunable light source beam and the second fixed light source beam to the one light beam combiner device.

In an example of this variant, the light source system further comprises a fiber optic switch configured to alternatingly provide the tunable light source beam and the second fixed light source beam to the one light beam combiner device.

In a variant of this embodiment, one light beam combiner device is configured to provide the fixed output light beam with the fixed output wavelength by combining the first fixed light source beam with the tunable light source beam tuned to the second fixed source wavelength, and the variable output light beam with the varying output wavelength by combining the first fixed light source beam with the tunable light source beam tuned to the varying source wavelength. The second light source is configured to alternatingly provide the tunable light source beam tuned to the varying source wavelength and the second fixed light source beam with the tunable light source beam tuned to the second fixed source wavelength.

In an embodiment, the one or more light beam combiner devices are nonlinear optical crystals.

In an embodiment, the light source system is used for semiconductor metrology. The fixed output light beam is usable for measuring relative displacement and the second output light beam is usable for measuring absolute position.

In an embodiment, the first fixed source wavelength is about 1562nm and the second fixed source wavelength is at a wavelength of about 1064nm.

In an embodiment, the light source system further comprising a wavelength tracker for tracking changes of the first fixed laser source beam, the second fixed laser source beam, and/or the tunable laser source beam

According to a second aspect of the invention, there is provided an interferometer system to determine a position of a movable object, comprising a light source system according to the first aspect of the invention, wherein the interferometer system is configured to determine the position of the movable object by projecting the fixed output light the variable output light beam along a measurement path.

According to a third aspect of the invention, there is provided a projection system for an optical lithography system comprising the interferometer system according to the second aspect of the invention.

According to a fourth aspect of the invention, there is provided an exposure apparatus, comprising the interferometer system according to the second aspect of the invention or the projection system according to the third aspect of the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a light source system according to an embodiment of the first aspect of the invention.
- Figure 3 depicts a light source system according to an embodiment of the first aspect of the invention.
- Figure 4 depicts a light source system according to an embodiment of the first aspect of the invention.
- Figure 5 depicts a light source system according to an embodiment of the first aspect of the invention.
- Figure 6 depicts (part of) a light source system according to one or more embodiments of the first aspect of the invention.

### DETAILED DESCRIPTION

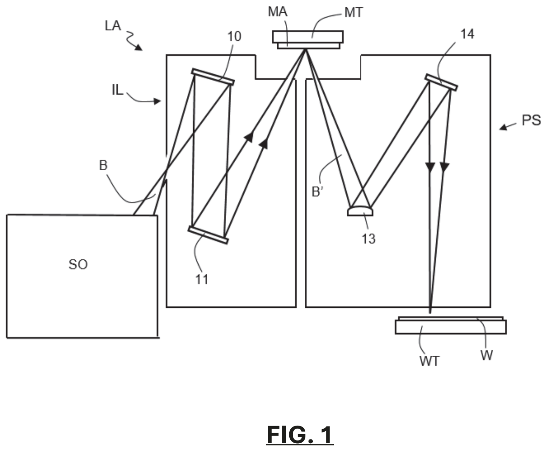

Figure 1 shows a lithographic system comprising a radiation source SO and a lithographic apparatus LA. The radiation source SO is configured to generate a radiation beam B (e.g., UV radiation, DUV radiation or EUV radiation) and to supply the radiation beam B to the lithographic apparatus LA. In the example of Figure 1, an EUV radiation beam B is generated and supplied to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

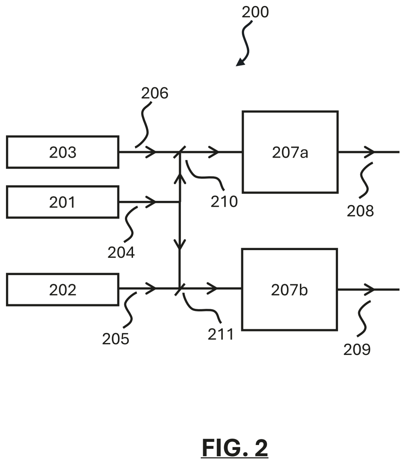

Figure 2 depicts a light source system 200 according to a first embodiment of the first aspect of the invention. The light source system 200 comprises a first light source 201, a second light source 202, and a third light source 203. The first light source 201 is configured to provide a first fixed light source beam 204 of a first fixed source wavelength. The second light source 202 is configured to provide a tunable light source beam 205 of a tunable source wavelength. The third light source 203 is configured to provide a second fixed light source beam 206 of a second fixed source wavelength. The first light source 201 may also be called a first fixed light source 201. The second light source 202 may also be called a tunable light source 202. The third light source 203 may also be called a second fixed light source 203.

The fixed light source beams 204, 206 may be within the optical telecommunications spectrum, e.g., within a range of 1260-1675nm. For example, the first fixed source wavelength of the first fixed light source 201 is about 1064nm and the second fixed source wavelength of the second fixed light source 203 is at a wavelength of about 1562nm. Alternatively, the first fixed source wavelength of the first fixed light source 201 is about 1562nm and the second fixed source wavelength of the second fixed light source 203 is about 1064nm. The variable light source beam 205 may likewise be within said optical telecommunications spectrum. The varying output wavelength of the variable light source beam 205 is for example varied over a spectral range of more than 1nm, preferably over a range of more than 2nm. In other words, the tunable light source 202 is configured to tune variable light source beam 205 over a range of more than 1nm, preferably over a range of more than 2nm. For example, the tunable light source 202 is configured to provide variable light source beam 205 within a tuning range of about 1063-1065nm or of about 1561-1563nm. The tunable light source 202 may be configured to continuously vary, i.e., tune the variable light source beam 205 within the tuning range. Said continuous varying or tuning of the variable light source beam 205 may be used for sweeping over the tuning range.

The first light source 201, the second light source 202, and/or the third light source 203 are for example lasers.

The first light source 201 may for example be a laser, for example a high-power pump laser source configured to deliver the first fixed light source beam 204 (i.e., a fixed optical output) centered at approximately 1064nm. The third light source 203 may for example be a laser, for example a high-power pump laser source configured to deliver the second fixed light source beam 206 (i.e., a fixed optical output) centered at approximately 1562nm. The fixed pump laser sources are designed to provide stable continuous-wave operation at an output power of about 500 mW, although higher or lower output powers may also be employed depending on application requirements. The fixed-wavelength laser sources (i.e., the fixed pump laser sources) may be realized using known configurations for high-power lasers. The fixed pump laser sources are for example configured with temperature and/or current control to ensure narrow linewidth emission and minimal wavelength drift during operation.

The second light source 202 is for example a laser, for example a tunable laser source configured to operate in the 1562 nm region with a wavelength tuning range greater than 1 nm, and preferably greater than 2 nm. This tunable laser source may be realized using known tunable laser architectures.

The light source system 200 further comprises two light beam combiner devices 207a, 207b. Light combiner device 207a is configured to combine first fixed light source beam 204 and second fixed light source beam 206 to provide a fixed output light beam 208 with a fixed output wavelength. The fixed output wavelength is for example in the spectral region from about 600nm to about 650nm, preferably about 633nm. Light combiner device 207b is configured to combine first fixed light source beam 204 and tunable light source beam 205 to provide a variable output light beam 209 with a varying output wavelength. The varying output wavelength is for example in the spectral region from about 600nm to about 650nm, preferably centered at 633nm. The varying output wavelength may be varied over a range of more than 1nm, preferably over a range of more than 2nm. For example, the varying output wavelength is varied in a range centered at 633nm, for example within a spectral range of 632-634nm.

The light beam combiner devices 207a, 207b may for example be nonlinear optical crystals. The nonlinear optical crystals are configured to combine their input light source beams by sum frequence mixing. The nonlinear optical crystals may be selected from, but are not limited to, beta barium borate (BBO), lithium triborate (LBO), potassium titanyl phosphate (KTP), potassium niobate (KNbO₃), bismuth triborate (BiBO), periodically poled lithium niobate (PPLN), or periodically poled potassium titanyl phosphate (PPKTP). These crystals provide efficient nonlinear interaction, allowing input light beams to be combined into an output light beam at the sum- or difference-frequency.

Light beam combiner device 207a may be configured to combine first fixed light source beam 204 and second fixed light source beam 206 using sum frequency mixing. The first fixed light source beam 204 and second fixed light source beam 206 may be arranged in a collinear configuration such that both propagate along a common optical axis into the light beam combiner device 207a. The beams 204, 206 may be combined prior to entry using a wavelength-selective combining optic 210, such as a dichroic mirror, or by means of a fiber-based coupler.

Light beam combiner device 207b may be configured to combine first fixed light source beam 204 and variable light source beam 205 using sum frequency mixing. The first fixed light source beam 204 and variable light source beam 205 may be arranged in a collinear configuration such that both propagate along a common optical axis into the light beam combiner device 207b. The beams 204, 205 may be combined prior to entry using a wavelength-selective combining optic 211, such as a dichroic mirror, or by means of a fiber-based coupler.

The fixed output light beam 208 is for example usable for measuring relative displacement and the second output light beam 209 is for example usable for measuring absolute position in a metrology tool used in semiconductor manufacturing, for example in a lithographic apparatus. The variable output light beam 209 may be used in such a metrology tool for calibration of the fixed output light beam 208.

In the configuration shown in Figure 2, the light source system 200 is configured, by using two light beam combiners 207a, 207b, to provide the fixed output light beam 208 and the variable output light beam 209 simultaneously.

The first fixed light source 201 is a shared light source for providing both the fixed output light beam 208 and the variable output light beam 209. This may enable reduction in the amount of light sources (lasers) required to provide the fixed output light beam 208 (usable for measuring relative displacement) and to provide the variable output light beam 209 (usable for absolute position). Operating the three light sources 201, 202, 203 in the telecommunications spectrum may contribute to increasing the reliability of the light source system 200. By tuning the second light source 202 in the telecommunications range (e.g., using grating based tuning), fast and reliable tuning (of the tunable light source beam 205 and/or the variable output light beam 209) may be achieved.

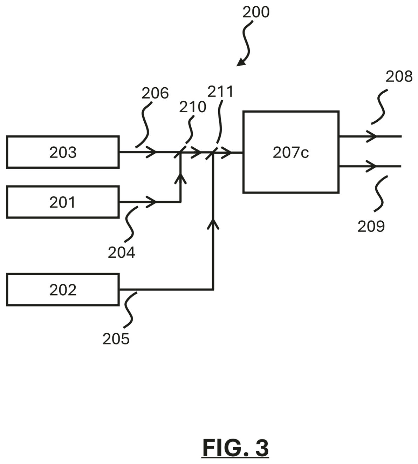

Figure 3 depicts a light source system 200 according to a second embodiment of the first aspect of the invention. Similarly to the embodiment shown in Fig. 2, the light source system 200 of the second embodiment comprises a first light source 201, a second light source 202, and a third light source 203. The first light source 201 is configured to provide a first fixed light source beam 204 of a first fixed source wavelength. The second light source 202 is configured to provide a tunable light source beam 205 of a tunable source wavelength. The third light source 203 is configured to provide a second fixed light source beam 206 of a second fixed source wavelength. The first light source 201 may also be called a first fixed light source 201. The second light source 202 may also be called a tunable light source 202. The third light source 203 may also be called a second fixed light source 203.

The light source system 200 further comprises a single (one) light beam combiner device 207c. Light combiner device 207c is configured to both provide fixed output light beam 208 with a fixed output wavelength and variable output light beam 209 with a varying output wavelength. To provide both the fixed output light beam 208 and the variable output light beam 209, the light combiner device 207c is provided with three input light beams: the first fixed light source beam 204, the tunable light source beam 205, and the second fixed light source beam 206. Light combiner device 207c is configured to provide the fixed output light beam 208 by combining first fixed light source beam 204 and second fixed light source beam 206. Light combiner device 207c is configured to provide the variable output light beam 209 by combining first fixed light source beam 204 and tunable light source beam 205.

The fixed output wavelength is for example in the spectral region from about 600nm to about 650nm, preferably about 633nm. The varying output wavelength is for example in the spectral region from about 600nm to about 650nm, preferably centered at 633nm. The varying output wavelength may be varied over a range of more than 1nm, preferably over a range of more than 2nm. For example, the varying output wavelength is varied in a range centered at 633nm, for example within a spectral range of 632-634nm.

Light source system 200 is configured to alternate the providing of the fixed output light beam 208 and the variable output light beam 209. For example, the light source system 200 is configured to control the tunable light source 202 and the second fixed light source 203 such that a single one of the tunable light source 202 and the second fixed light source 203 emits light that is provided to the light beam combiner device 207c. In other words, the second light source 202 and the third light source 203 are configured to alternatingly provide the tunable light source beam and the first fixed light source beam to the one light beam combiner device 207c. So, the second light source 202 only transmits light when the third light source 203 does not transmit light, and vice versa.

Light beam combiner device 207c may be configured to combine first fixed light source beam 204 and second fixed light source beam 206 using sum frequency mixing. The first fixed light source beam 204 and second fixed light source beam 206 may be arranged in a collinear configuration such that, when the third light source 203 emits second fixed light source beam 206, both the fixed light source beam 204 and second fixed light source beam 206 propagate along a common optical axis into the light beam combiner device 207c. The beams 204, 206 may be combined prior to entry using a wavelength-selective combining optic 210, such as a dichroic mirror, or by means of a fiber-based coupler. When the third light source 203 does not emit second fixed light source beam 206, the wavelength-selective combining optic 210 may be configured to transmit the first fixed light source beam 204 unaltered.

Light beam combiner device 207c may be configured to combine first fixed light source beam 204 and variable light source beam 205 using sum frequency mixing. The first fixed light source beam 204 and variable light source beam 205 may be arranged in a collinear configuration such that both propagate along a common optical axis into the light beam combiner device 207c. When the third light source 203 does not emit second fixed light source beam 206, the beams 204, 205 may be combined prior to entry using a wavelength-selective combining optic 211, such as a dichroic mirror, or by means of a fiber-based coupler. When the second light source 202 does not emit variable light source 205, the wavelength-selective combining optic 210 may be configured to transmit the combined beams 204, 206.

This second embodiment may additionally contribute to a reduction in components of the light source system 200. Compared to the first embodiment shown in Fig. 2, only a single light beam combiner device is required which is configured to provide both the fixed output light beam 208 and the variable output light beam 209.

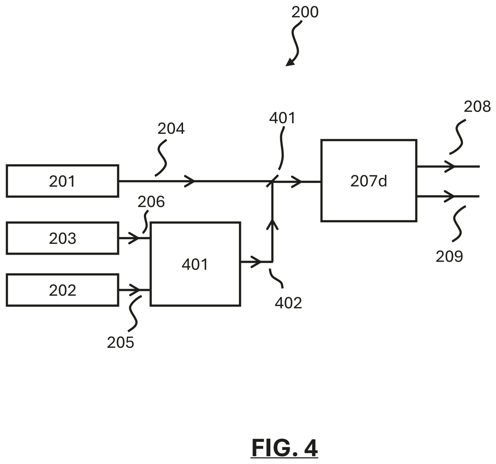

Figure 4 depicts a light source system 200 according to a variant of the second embodiment of the first aspect of the invention. Similarly to the embodiment shown in Fig. 3, the light source system 200 of this variant comprises a first light source 201, a second light source 202, and a third light source 203. The light source system 200 similarly comprises a single (one) light beam combiner device 207d. Light combiner device 207d is configured to both provide fixed output light beam 208 with a fixed output wavelength and variable output light beam 209 with a varying output wavelength. Light combiner device 207d is provided with two input light beams: the first input light beam is fixed light source beam 204 and the second input light beam is light beam 402, which light beam 402 is selected from variable light source beam 205 and second fixed light source beam 206.

In this embodiment, light source system 200 is configured to alternate the providing of the fixed output light beam 208 of fixed output wavelength and the variable output light beam 209 of varying output wavelength.

The fixed output wavelength is for example in the spectral region from about 600nm to about 650nm, preferably about 633nm. The varying output wavelength is for example in the spectral region from about 600nm to about 650nm, preferably centered at 633nm. The varying output wavelength may be varied over a range of more than 1nm, preferably over a range of more than 2nm. For example, the varying output wavelength is varied in a range centered at 633nm, for example within a spectral range of 632-634nm.

The light source system 200 comprises a fiber optic switch 401 configured to alternatingly provide the second fixed light source beam 206 and the tunable light source beam 205 to the one light beam combiner device 207d. In other words, the light source system 200 selects one of the second fixed light source beam 206 and the tunable light source beam 205 to propagate as the second input light beam 402 to the one light beam combiner device 207d.

Light beam combiner device 207d may be configured to combine first fixed light source beam 204 and the second input light beam 402 using sum frequency mixing. The first fixed light source beam 204 and second input light beam 402 may be arranged in a collinear configuration such that both propagate along a common optical axis into the light beam combiner device 207d. The beams 204, 402 may be combined prior to entry using a wavelength-selective combining optic 401, such as a dichroic mirror, or by means of a fiber-based coupler.

This variant may further contribute to the reduction of the complexity of the light source system 200. In comparison to the second embodiment shown in Fig. 3, the light beam combiner device 207d in Fig. 4 is only configured to combine two input beams rather than three input beams. The amount of combining optics may additionally be reduced in this variant.

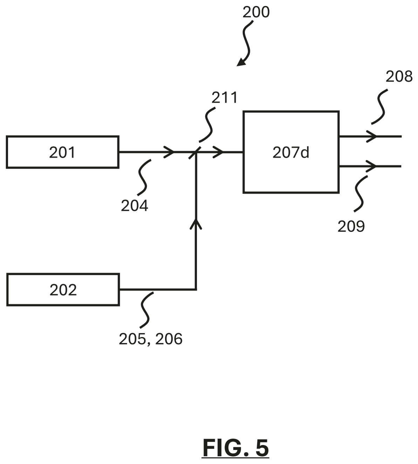

Figure 5 depicts a light source system 200 according to a third embodiment of the first aspect of the invention. The light source system 200 comprises a first light source 201 and a second light source 202. The first light source 201 is configured to provide a first fixed light source beam 204 of a first fixed source wavelength. The second light source 202 is configured to provide a tunable light source beam 205 of a tunable source wavelength. The first light source 201 may also be called a first fixed light source 201. The second light source 202 may also be called a tunable light source 202.

In this embodiment, light source system 200 is configured to alternate the providing of the fixed output light beam 208 of fixed output wavelength and the variable output light beam 209 of varying output wavelength.

The tunable light source 202 is configured to either be tuned to the varying source wavelength or to the second source wavelength. Thus, the tunable light source 202 is also configured to provide second fixed light source beam 206. Thus, the tunable light source 202 can be operated in two modes: a first mode in which the second light source 202 provides the tunable light source beam 205 of the tunable (i.e., varying) source wavelength and a second mode in which the second light source 202 provides the second fixed light source beam 206 by keeping the light source 202 stable at the second fixed source wavelength. The tunable light source 202 is either operated in the first mode or the second mode, i.e., the tunable light source 202 alternates the providing of tunable light source beam 205 and second fixed light source beam 206. The light source system 200 is configured to switch operation from the first mode to the second mode to provide the fixed output light beam 208, and to switch operation from the second mode to the first mode to provide the variable output light beam 208.

For example, the first fixed light source 201 is configured to provide first fixed light source beam 204 at a wavelength of about 1064nm, and the tunable light source 202 is configured to provide tunable light source beam 205 within a tuning range of about 1561-1563nm in its first mode. In this example, the tunable light source 202 is configured to provide second fixed source light beam 206 at a wavelength of about 1562nm in its second mode. In another example, the first fixed light source 201 is configured to provide first fixed light source beam 204 at a wavelength of about 1562nm, and the tunable light source 202 is configured to provide tunable light source beam 205 within a tuning range of about 1063-1065nm in its first mode. In this example, the tunable light source 202 is configured to provide second fixed light source beam 206 at a wavelength of about 1064nm in its second mode.

Light beam combiner device 207d may be configured to combine first fixed light source beam 204 and one of the tunable light source beam 205 and second fixed light source beam 206 using sum frequency mixing. The first fixed light source beam 204 and tunable light source beam 205 and second fixed light source beam 206 may be arranged in a collinear configuration such that both propagate along a common optical axis into the light beam combiner device 207d. The beams 204 and beams 205/206 may be combined prior to entry using a wavelength-selective combining optic 211, such as a dichroic mirror, or by means of a fiber-based coupler.

This third embodiment may further contribute to the reduction in components of the light source system 200. Only two light sources are arranged, in comparison to the three light sources arranged in the embodiments shown in Figs. 2-4. By also operating the second light source 202 at the second fixed source wavelength, the second light source 202 is configured to also perform the function of the third light source 203.

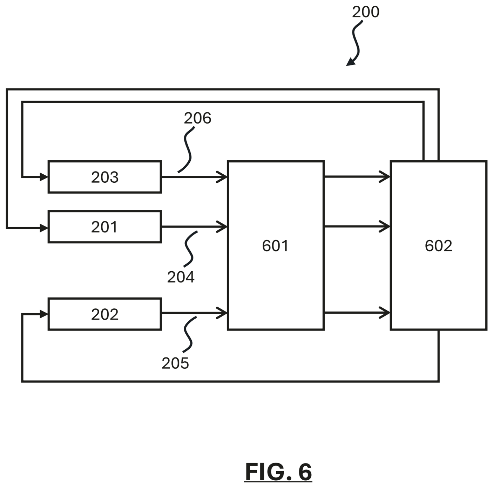

Figure 6 depicts (part of) a light source system according to one or more embodiments (i.e., one or more of the first, second, and/or third embodiments) of the first aspect of the invention. The light source system 200 comprises a first light source 201 and a second light source 202. The first light source 201 is configured to provide a first fixed light source beam 204 of a first fixed source wavelength. The second light source 202 is configured to provide a tunable light source beam 205 of a tunable source wavelength. The first light source 201 may also be called a first fixed light source 201. The second light source 202 may also be called a tunable light source 202.

The light source system 200 further comprises a wavelength tracker 601 configured for tracking changes of the first fixed laser source beam 204, the second fixed laser source beam 206, and/or the tunable laser source beam 205.

The wavelength tracker 601 is for example configured to monitor and stabilize the emission wavelength of fixed-output laser sources 203 and 201. Even for nominally fixed-wavelength sources such as 1064nm or 1562nm lasers, environmental variations including temperature drift, drive current fluctuations, and aging of the gain medium may cause small but undesirable wavelength shifts. The wavelength tracker 601 operates by known techniques to produce a feedback signal indicative of deviations from the desired wavelength. This feedback signal is supplied to a control circuit 602 which adjusts laser operating parameters such as injection current, cavity temperature, or pump power of the fixed-output lasers 203 and 201. Therewith, the output of the fixed-wavelength sources approaches or is equal to the target wavelength which may contribute to long-term spectral stability of the fixed laser source beam 204 and/or the second fixed laser source beam 206.

The wavelength tracker 601 is for example configured to control tunable laser source 202, which contributes to precise and repeatable tuning across the operating range of the tunable laser source 202. The wavelength tracker 601 samples a portion of the tunable laser source beam 205 and compares the measured wavelength against a reference or calibration element. When the tunable light source 202 is tuned, for example by varying cavity length, current, or grating angle, the wavelength tracker 601 continuously monitors the actual emission wavelength which produces a feedback signal indicative of deviations from the desired wavelength. This feedback signal is supplied to control circuit 602 which, in a feedback loop, compensates for nonlinear tuning responses, hysteresis, or thermal drift. Said control may contribute to the system accurately reaching and maintaining a desired varying wavelength, e.g., during a wavelength sweep. For example, this arrangement enables dynamic wavelength sweeping over more than 1 nm, preferably more than 2 nm, while maintaining narrow linewidth and spectral stability. Such wavelength tracking ensures reliable operation in applications such as precision metrology, e.g. for lithography.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Further, this document describes the following clauses of the present invention:
1. A light source system configured to provide a fixed output light beam with a fixed output wavelength and a variable output light beam with a varying output wavelength comprising:
   a first light source configured to provide a first fixed light source beam of a first fixed source wavelength;
   a second light source configured to provide a tunable light source beam of a tunable source wavelength;
   one or more light beam combiner devices configured to combine a plurality of light source beams;
   wherein:
      the one or more light beam combiner devices are configured to provide:
         the fixed output light beam with the fixed output wavelength by combining the first fixed light source beam with the tunable light source beam tuned to a second fixed source wavelength; and
         the variable output light beam with the varying output wavelength by combining the first fixed light source beam with the tunable light source beam tuned
      to a varying source wavelength;
   or wherein:
      the light system comprises a third light source configured to provide a second fixed light source beam of the second fixed source wavelength;
      the one or more light beam combiner devices are configured to provide:
         the fixed output light beam with the fixed output wavelength by combining the first fixed light source beam with the second fixed light source beam; and
         the variable output light beam with the varying output wavelength by combining the first fixed light source beam with the tunable light source beam tuned to the varying source wavelength.
2. The light source system according to clause 1, wherein the light source system is configured to provide the fixed output light beam and the variable output light beam simultaneously.
3. The light source system according to clause 2, wherein:
   the one or more light beam combiner devices comprise a first light beam combiner device and a second light beam combiner device;
   the first light beam combiner device is configured to provide the fixed output light beam with the fixed output wavelength by combining the first fixed light source beam with the second fixed light source beam; and
   the second light beam combiner device is configured to provide the variable output light beam with the varying output wavelength by combining the first fixed light source beam with the tunable light source beam tuned to the varying source wavelength.
4. The light source system according to clause 1, wherein the light source system is configured to alternate the providing of the fixed output light beam and the variable output light beam.
5. The light source system according to clause 4, wherein:
   one light beam combiner device is configured to provide:
   the fixed output light beam with the fixed output wavelength by combining the first fixed light source beam with the second fixed light source beam; and
   the variable output light beam with the varying output wavelength by combining the first fixed light source beam with the tunable light source beam tuned to the varying source wavelength.
6. The light source system according to clause 5, wherein the second light source and the third light source are configured to alternatingly provide the tunable light source beam and the second fixed light source beam to the one light beam combiner device.
7. The light source system according to any one of clauses 5-6, further comprising a fiber optic switch configured to alternatingly provide the second fixed light source beam and the tunable light source beam to the one light beam combiner device.
8. The light source system according to clause 4, wherein:
   one light beam combiner device is configured to provide:
      the fixed output light beam with the fixed output wavelength by combining the first fixed light source beam with the tunable light source beam tuned to the second fixed source wavelength; and
      the variable output light beam with the varying output wavelength by combining the first fixed light source beam with the tunable light source beam tuned to the varying source wavelength;
   the second light source is configured to alternatingly provide the tunable light source beam tuned to the varying source wavelength and the second fixed light source beam with the tunable light source beam tuned to the second fixed source wavelength.
9. The light source system according to any one of the preceding clauses, wherein the one or more light beam combiner devices are nonlinear optical crystals.
10. The light source system according to any one of the preceding clauses, wherein the one or more light beam combiner devices are configured to combine the light source beams by sum frequency mixing.
11. The light source system according to any one of the preceding clauses used for semiconductor metrology, wherein the fixed output light beam is usable for measuring relative displacement and the second output light beam is usable for measuring absolute position.
12. The light source system according to any one of the preceding clauses, wherein the variable output light beam is used for calibration of the fixed output light beam.
13. The light source system according to any of the preceding clauses wherein one or more of the light source beams are within the optical telecommunications spectrum.
14. The light source system according to any one of the preceding clauses, wherein the first fixed source wavelength is about 1562nm and the second fixed source wavelength is at a wavelength of about 1064nm.
15. The light source system according to any one of the preceding clauses, wherein the fixed output wavelength is in the spectral region from about 600nm to about 650nm, preferably about 633nm.
16. The light source system according to any one of the preceding clauses, wherein the varying output wavelength is in the spectral region from about 600nm to about 650nm, preferably about 633nm.
17. The light source system according to any one of the preceding clauses, wherein the varying output wavelength is varied over a range of more than 1nm, preferably over a range of more than 2nm.
18. The light source system according to any one of the preceding clauses, further comprising a wavelength tracker for tracking changes of the first fixed laser source beam, the second fixed laser source beam, and/or the tunable laser source beam.
19. The light source system according to any one of the preceding clauses, wherein the first light source, the second light source, and/or the third light source are lasers.
20. An interferometer system to determine a position of a movable object, comprising a light source system according to any one of clauses 1-19, wherein the interferometer system is configured to determine the position of the movable object by projecting the fixed output light the variable output light beam along a measurement path.
21. A projection system for an optical lithography system comprising the interferometer system according to clause 20.
22. An exposure apparatus, comprising the interferometer system according to clause 20 or the projection system according to clause 21.

## Claims

1. A light source system configured to provide a fixed output light beam with a fixed output wavelength and a variable output light beam with a varying output wavelength comprising:
a first light source configured to provide a first fixed light source beam of a first fixed source wavelength;
a second light source configured to provide a tunable light source beam of a tunable source wavelength;
one or more light beam combiner devices configured to combine a plurality of light source beams;
wherein:
the one or more light beam combiner devices are configured to provide:
the fixed output light beam with the fixed output wavelength by combining the first fixed light source beam with the tunable light source beam tuned to a second fixed source wavelength; and
the variable output light beam with the varying output wavelength by combining the first fixed light source beam with the tunable light source beam tuned to a varying source wavelength;
or wherein:
the light system comprises a third light source configured to provide a second fixed light source beam of the second fixed source wavelength;
the one or more light beam combiner devices are configured to provide:
the fixed output light beam with the fixed output wavelength by combining the first fixed light source beam with the second fixed light source beam; and
the variable output light beam with the varying output wavelength by combining the first fixed light source beam with the tunable light source beam tuned to the varying source wavelength.

2. The light source system according to claim 1, wherein the light source system is configured to provide the fixed output light beam and the variable output light beam simultaneously.

3. The light source system according to claim 2, wherein:
the one or more light beam combiner devices comprise a first light beam combiner device and a second light beam combiner device;
the first light beam combiner device is configured to provide the fixed output light beam with the fixed output wavelength by combining the first fixed light source beam with the second fixed light source beam; and
the second light beam combiner device is configured to provide the variable output light beam with the varying output wavelength by combining the first fixed light source beam with the tunable light source beam tuned to the varying source wavelength.

4. The light source system according to claim 1, wherein the light source system is configured to alternate the providing of the fixed output light beam and the variable output light beam.

5. The light source system according to claim 4, wherein:
one light beam combiner device is configured to provide:
the fixed output light beam with the fixed output wavelength by combining the first fixed light source beam with the second fixed light source beam; and
the variable output light beam with the varying output wavelength by combining the first fixed light source beam with the tunable light source beam tuned to the varying source wavelength.

6. The light source system according to claim 5, wherein the second light source and the third light source are configured to alternatingly provide the tunable light source beam and the second fixed light source beam to the one light beam combiner device.

7. The light source system according to any one of claims 5-6, further comprising a fiber optic switch configured to alternatingly provide the second fixed light source beam and the tunable light source beam to the one light beam combiner device.

8. The light source system according to claim 4, wherein:
one light beam combiner device is configured to provide:
the fixed output light beam with the fixed output wavelength by combining the first fixed light source beam with the tunable light source beam tuned to the second fixed source wavelength; and
the variable output light beam with the varying output wavelength by combining the first fixed light source beam with the tunable light source beam tuned to the varying source wavelength;
the second light source is configured to alternatingly provide the tunable light source beam tuned to the varying source wavelength and the second fixed light source beam with the tunable light source beam tuned to the second fixed source wavelength.

9. The light source system according to any one of the preceding claims, wherein the one or more light beam combiner devices are nonlinear optical crystals.

10. The light source system according to any one of the preceding claims used for semiconductor metrology, wherein the fixed output light beam is usable for measuring relative displacement and the second output light beam is usable for measuring absolute position.

11. The light source system according to any one of the preceding claims, wherein the first fixed source wavelength is about 1562nm and the second fixed source wavelength is at a wavelength of about 1064nm.

12. The light source system according to any one of the preceding claims, further comprising a wavelength tracker for tracking changes of the first fixed laser source beam, the second fixed laser source beam, and/or the tunable laser source beam.

13. An interferometer system to determine a position of a movable object, comprising a light source system according to any one of claims 1-12, wherein the interferometer system is configured to determine the position of the movable object by projecting the fixed output light the variable output light beam along a measurement path.

14. A projection system for an optical lithography system comprising the interferometer system according to claim 13.

15. An exposure apparatus, comprising the interferometer system according to claim 13 or the projection system according to claim 14.
